**Europäisches Patentamt**

**European Patent Office**

**Office européen des brevets**

(19)

(11) Publication number : **0 321 738 B1**

# EUROPEAN PATENT SPECIFICATION

(12)

(45) Date of publication of patent specification :
07.09.94 Bulletin 94/36

(51) Int. Cl.⁵ : **H01L 29/06, H01L 21/76, H01L 27/088**

(21) Application number : **88119785.9**

(22) Date of filing : **28.11.88**

(54) **MOS transistor with enhanced isolation capabilities.**

(30) Priority : **23.12.87 US 137278**

(43) Date of publication of application :
28.06.89 Bulletin 89/26

(45) Publication of the grant of the patent :
07.09.94 Bulletin 94/36

(84) Designated Contracting States :
**DE FR GB NL**

(56) References cited :
DE-A- 3 100 288
US-A- 4 063 274
PATENT ABSTRACTS OF JAPAN, vol. 9, no.
201 (E-336)[1924], 17th August 1985 & JP-A-60
66 444

(73) Proprietor : **TEXAS INSTRUMENTS INCORPORATED**
**13500 North Central Expressway**
**Dallas Texas 75265 (US)**

(72) Inventor : **Tigelaar, Howard L.**
**505 Meadowcreek**
**Allen, Texas 75002 (US)**
Inventor : **Paterson, James L.**
**422 Brook Glen Drive**
**Richardson, Texas 75080 (US)**

(74) Representative : **Leiser, Gottfried, Dipl.-Ing. et al**
**Prinz & Partner,**
**Manzingerweg 7**
**D-81241 München (DE)**

## Description

### TECHNICAL FIELD OF THE INVENTION

This invention pertains in general to integrated circuits, and more particularly to an integrated circuit of the type defined in the pre-characterizing part of claim 1. Further it relates to a method of forming isolated MOS transistors.

In JP-A-60-66 444 & Patent Abstracts of Japan, vol. 9, no. 201 (E-336)[1924] August 17, 1985 an integrated circuit is described in which an electrode is formed on a field insulating film provided between MOS transistors. The electrode is held at the same potential as the substrate on which said MOS transistors are provided. In their structure the generation of leakage currents can be prevented.

### BACKGROUND OF THE INVENTION

In the field of integrated circuits, it is necessary to provide isolation between active devices, thereby preventing conduction between the diffused regions of different transistors. Normally, isolation is provided by field oxide regions which form a large dielectric area between the diffused regions of the different transistors.

However, field oxide regions require a large amount of surface area to provide adequate isolation. As the density of transistors on a semiconductor surface increases, the overhead required by the field oxide regions can no longer be tolerated. Thus, an alternative means of providing isolation is need.

In many cases, isolation is provided by an "isolating transistor," which comprises a gate region between the diffused regions of two different transistors. The gate is biased such that the isolating transistor is turned off, thereby preventing conduction between the diffused regions. To provide an isolating transistor between two N type regions, the gate of the isolating transistor is usually grounded to turn off the transistor. However, during operation, noise spikes or ground bounce may cause the voltage threshold of about 2.5 volts to be exceeded, and hence, conduction between the diffused regions will occur. Consequently, the reliability of the device is reduced. While a voltage threshold of 2.5 volts is typical of today's technology, reduction of gate voltages will reduce the voltage threshold, further increasing the problem.

Therefore, a need has arisen in the industry for an isolating transistor structure which reliably prevents conduction between diffused regions.

### SUMMARY OF THE INVENTION

In the integrated circuit of the invention which has the features of the characterizing part of claim 1, an isolating transistor is provided which substantially eliminates or prevents the disadvantages and problems associated with prior isolating devices.

The isolating transistor of the present invention uses a gate region having an impurity type which is the same as the underlying semiconductor surface with which it is associated. Therefore, if isolating is desired between two N type diffusion regions, a P type polysilicon gate is used, since a P type semiconductor region will be present between the N type diffused regions. Conversely, if isolation is desired between two P+ type diffusion regions, then an N type polysilicon gate is used.

The present invention provides the technical advantage of a small isolating device, in which the voltage threshold between the gate region and the diffused region is maximized by taking advantage of different work function between N type and P type polysilicon. This allows the turn-on voltage of the field transistor isolating N channel transistors to be raised by approximately one volt without increasing the isolation oxide thickness. This difference will become increasingly important as devices and operating voltages are scaled smaller.

### BRIEF DESCRIPTION OF THE DRAWINGS

For a more complete understanding of the present invention and the advantages thereof, reference is now made to the following descriptions taken in conjunction with the accompanying drawings in which:

FIGURE 1 illustrates prior art isolating transistor;
FIGURE 2 illustrates the isolating transistor of the present invention; and
FIGURE 3a-b illustrates a process for forming enhanced isolating transistors between P channel and N channel transistors without additonal masking steps.

### DETAILED DESCRIPTION OF THE INVENTION

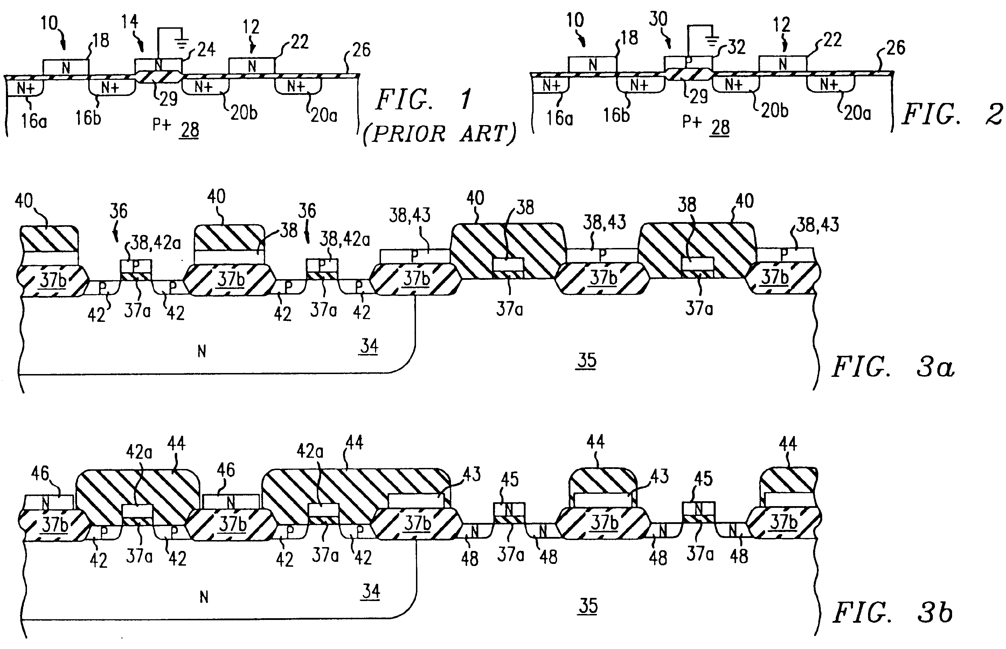

The preferred embodiment of the present invention is best understood by referring to FIGUREs 1-3 of the drawings, like numerals being used for like and corresponding parts of the various drawings.

FIGURE 1 illustrates a prior art isolating transistor, used to isolate between two N+ diffused regions. As shown, two active N channel transistors 10 and 12 are separated by an isolating transistor 14. The N channel transistor 10 has N+ source/drain regions 16a-b and a polysilicon gate 18, while the N channel transistor 12 has source/drain regions 20a-b and gate 22. The isolating transistor 14 shares a source/drain region 16b with the transistor 10 and a source/drain region 20b with the transistor 12. The gate 24 of the isolating transistor 14 is connected to ground. A thin gate oxide layer 26 separates the gates 18 and 22 from the underlying semiconductor surface 28 and a thicker gate oxide 29 separates the isolating gate 24 from the underlying semiconductor surface 28.

The gate 24 of the N channel isolating transistor 14 is maintained at ground voltage (zero volts). Normally, this will be sufficient to prevent a flow of electrons between the source/drain regions 16b and 20b associated with the isolating transistor. However, during operation of the active transistors 10 and 12, voltage spikes or ground bounce may cause the voltage to exceed the voltage threshold of the isolating transistor 14. In this instance, the isolating transistor 14 would turn on, thereby allowing current to flow between the source/drain regions 16b and 20b.

One way to prevent the inadvertent conduction described above would be to connect the gate 24 of the isolating transistor 14 to a negative voltage. However, in practice, this solution would require that an additional negative voltage would have to be supplied on chip which would add to the complexity and cost making it undesirable.

FIGURE 2 illustrates a isolating transistor of the present invention. In this instance, the isolating transistor 30 comprises a P-type polysilicon gate over the channel between the source/drain regions 16b and 20b. The work function of the P type polysilicon s approximately one volt higher than that of the N type polysilicon used in prior art. This advantageously raises the turn-on voltage of the isolation transistor 30 by approximately one volt over that of isolating transistor 14. This higher threshold voltage of the isolating transistor 30 of the present invention allows a greater charge to be present on either of the source/drain regions 16b or 20b before conduction occurs between the source/drain regions.

The gate 32 of the isolating transistor 30 of the present invention may be doped in conjunction with the P type source/drain implantation for the P channel transistors, thereby saving an implantation step. To do so, the gates which should remain N type must be masked prior to the implantation. Since a mask is already used for this purpose during source/drain implantation (See FIGUREs 3a-b), no additonal masking steps would be needed.

Similarly, the isolating gates formed between adjacent P channel transistors should be doped with an N type dopant in order to increase the threshold voltage of the isolating transistors.

The threshold voltage of a transistor is determined primarily by the work function of the gate, the substrate doping, and the thickness of the gate oxide. When transistors are used, as in the case of field plates, to provide isolation between adjacent transistors, the threshold voltage is made as high as possible to prevent the isolation transistor from turning on. In prior art, the oxide is made thick and the substrate doped with a channel stop implant to raise the substrate doping thus raising the threshold voltage. As devices are scaled smaller and higher speed parts are demanded, limits are imposed upon the isolation oxide thickness and the channel stop implant dose. This disclosure teaches the use of the difference in work function between N type and P type polysilicon gates to further improve isolation. The turn-on voltage is directly proportional to the difference between the work function of the gate material and that of the underlying substrate.

$$Vt \; \alpha \; \phi_{gate} \; - \; \phi_{substrate} \; = \; \phi_{ms}$$

For N type polysilicon gate = 4.15 and for P type polysilicon $\phi$ gate = 5.25. Thus, by using P type polysilicon rather than N type polysilicon for field plate isolation over the P wells, the Vt of the isolation transistors can be raised by at least one volt.

A process to dope the isolating gates and diffused regions of the transistors is illustrated in FIGUREs 3a-b. After forming the Nwell region 34 in the P substrate 35 for housing the P channel transistors 36, the gate oxide layer 37a, field oxide regions 37b, and the undoped polysilicon gates 38 are formed using standard processes. A photoresist mask 40 is patterned to expose the regions in which the P type source/drains 42, P channel gates 42a, and the P type isolating gates 43 will be formed. The exposed regions are doped with a P type dopant, typically by implantation and diffusion.

In FIGURE 3b, a second photoresist mask 44 covers the P type source/drains 42, and P channel gates 42a are along with the P type isolating gate 43 and an N type dopant is used to dope the remaining MOS transistor gates 45, the N type isolating gate 46 and the N type source/drains 48. Subsequently, the photoresist mask 44 is removed.

Since the masks 40 and 44 would normally be used in a CMOS process to define the source/drains 48, additional masks are not necessary to implement the process of the present invention.

It should be noted that p-n junctions formed in the polysilicon where the n type and p type regions meet would be a problem if a silicide layer on the polysilicon were not used to short out these junctions. Using current silicide technologies, this problem is avoided.

The present invention provides the technical advantage that a reliable isolating transistor is provided without additional masking steps or implantations. The isolating transistor has a high threshold voltage thereby reducing the possibility of inadvertant conduction between its associated source/drain regions.

## Claims

1. An integrated circuit comprising an isolating MOS transistor (30) for providing isolation between two N channel MOS devices (10, 12), said isolation MOS transistor (30) comprising:

    a P type semiconductor region (28);

    two N type source/drain regions (16b, 20b) formed in said P type semiconductor region (28), one of said source/drain regions (16b) associated with one (10) of the N channel devices and the other source/drain region (20b) associated with the other N channel device (12); and

a gate region (32) separated from said P type semiconductor region (28) by a thick insulating layer (29) and defining a channel between said source/drain regions (16b, 20b), said gate region (32) being connected to a predetermined voltage to render said channel non-conductive, characterized in that said gate region (32) is of P type conductivity to provide an increased threshold voltage and thereby reduce the possibility of inadvertant conduction between said source/drain regions (16b, 20b).

2. The integrated circuit of claim 1, wherein said source/drain regions (16b, 20b) comprise N+ type diffusion regions.

3. The integrated circuit of claim 1, wherein said predetermined voltage is ground voltage.

4. The integrated circuit of claim 1 further comprising a second isolation MOS transistor for providing electrical isolation between P-channel transistors having P type source/drain regions formed in an N type semiconductor region, said second isolation MOS transistor comprising:

N type gate regions separated from the N type semiconductor region between one of the P-channel and N-channel transistors.

5. A method of providing isolation between two N type diffused regions (16b, 20b) disposed in a P type semiconductor region (28), comprising the steps of:

providing a P type polysilicon gate region (32) separated from the portion of the semiconductor region (28) between the diffused regions (16b, 20b) by a thick insulating layer (29); and

applying a predetermined voltage to the polysilicon gate region (32).

6. The method of claim 5 wherein said step of appyling a predetermined voltage comprises the step of applying ground voltage to said polysilicon gate (32).

7. A method of forming isolated MOS transistors (36) in an integrated circuit, ones of the transistors (36) having source/drain regions (42) of a first conductivity type formed in a semiconductor region (34) of a second conductivity type and other ones of the transistors have a source/drain regions (48) of the second conductivity type formed in a semiconductor region (35) of the first conductivity type, comprising the steps of:

forming thick oxide regions (37b) on the semiconductor region (35) of the first conductivity type between adjacent transistors having source/drain regions (48) of the second conductivity type and forming isolating gates (43) of a first conductivity type on said oxide regions (37b);

forming thick oxide regions (37b) on the semiconductor region (34) of the second conductivity type between adjacent transistors (36) having source/drain regions (42) of the first conductivity type and forming isolating gates (46) of a second conductivity type on said oxide regions (37b); and

forming interconnects between said isolating gates and a predetermined voltage.

8. The method of claim 7 wherein step of forming said isolating gate comprises the steps of:

forming a polysilicon layer over the semiconductor region (34,35) of the first and second conductivity types;

removing portions of said polysilicon layer to define gates for the MOS transistors and said isolating gates;

doping the isolating gates (46) between source/drain regions (42) of the first conductivity type with a dopant of a second conductivity type; and

doping the isolating gates (43) between source/drain regions (48) of the second conductivity type with a dopant of the first conductivity type.

9. The method of claim 8 wherein said step of doping said isolating gates (46) between source/drain regions (42) of the first conductivity type comprises the steps of:

forming a first mask exposing the source/drain regions (42) of the first conductivity type and isolating gates (43) between source/drain regions (48) of the second conductivity type; and

doping the source/drain regions and isolating gate regions exposed by said first mask with a dopant of the first conductivity type.

10. The method of claim 9 wherein said step of doping the isolating gates (43) between source/drain regions (48) of the second conductivity type comprises the steps of:

forming a second mask exposing the source/drain regions (48) of the second conductivity type and isolating gates (46) between source/drain regions (42) of the first conductivity type; and

doping the source/drain regions and isolating gate regions exposed by said second mask with a dopant of the second conductivity type.

11. The method of claim 7 wherein said forming interconnects step comprises the step of forming interconnects between said isolating gates and ground voltage.

**Patentansprüche**

1. Integrierte Schaltung mit einem Isolier-MOS-Transistor (30) zur Schaffung einer Isolierung zwischen zwei N-Kanal-MOS-Einrichtungen (10, 12), wobei der Isolier-MOS-Transistor (30) folgendes enthält:
    eine Halbleiterzone (28) vom P-Typ;
    zwei Source/Drain-Zonen (16b, 20b) vom N-Typ, die in der Halbleiterzone (28) vom P-Typ gebildet sind, wobei eine der Source/Drain-Zonen (16b) einer (10) der N-Kanal-Einrichtungen und die andere Source/Drain-Zone (20b) der anderen N-Kanal-Einrichtung (12) zugeordnet ist; und
    eine Gate-Zone (32), die von der Halbleiterzone (28) vom P-Typ durch eine dicke Isolierschicht (29) getrennt ist und einen Kanal zwischen den Source/Drain-Zonen (16b, 20b) festlegt, wobei die Gate-Zone (32) an eine vorbestimmte Spannung angeschlossen ist, um den Kanal nichtleitend zu machen, dadurch gekennzeichnet, daß die Gate-Zone (32) vom P-Leitfähigkeitstyp ist, um eine erhöhte Schwellenspannung zu liefern und dadurch die Möglichkeit einer unbeabsichtigten Leitung zwischen den Source/Drain-Zonen (16b, 20b) zu verringern.

2. Integrierte Schaltung nach Anspruch 1, bei der die Source/Drain-Zonen (16b, 20b) Diffusionszonen vom N+-Typ enthalten.

3. Integrierte Schaltung nach Anspruch 1, bei der die vorbestimmte Spannung Erdspannung ist.

4. Integrierte Schaltung nach Anspruch 1, die ferner einen zweiten Isolier-MOS-Transistor zur Schaffung einer elektrischen Isolierung zwischen P-Kanal-Transistoren enthält, die P-Typ-Source/Drain-Zonen aufweisen, die in einer Halbleiterzone vom N-Typ gebildet sind, wobei der zweite Isolier-MOS-Transistor folgendes enthält:
    N-Typ-Gate-Zonen, die von der N-Typ-Halbleiterzone zwischen jeweiligen P-Kanal- und N-Kanal-Transistoren getrennt ist.

5. Verfahren zur Schaffung einer Isolierung zwischen zwei diffundierten Zonen (16b, 20b) vom N-Typ, die in einer Halbleiterzone (28) vom P-Typ angeordnet sind, mit den Schritten:
    Schaffen einer Polysilizium-Gate-Zone (32) vom P-Typ, die von dem Abschnitt der Halbleiterzone (28) zwischen den diffundierten Zonen (16b, 20b) durch eine dicke Isolierschicht (29) getrennt ist; und
    Anlegen einer vorbestimmten Spannung an die Polysilizium-Gate-Zone (32).

6. Verfahren nach Anspruch 5, bei dem der Schritt des Anlegens einer vorbestimmten Spannung den Schritt des Anlegens einer Erdspannung an das Polysilizium-Gate (32) enthält.

7. Verfahren zur Bildung isolierter MOS-Transistoren (36) in einer integrierten Schaltung, wobei bestimmte Transistoren (36) Source-Drain-Zonen (42) von einem ersten Leitfähigkeitstyp aufweisen, die in einer Halbleiterzone (34) von einem zweiten Leitfähigkeitstyp gebildet sind, und andere Transistoren Source/Drain-Zonen (48) von dem zweiten Leitfähigkeitstyp aufweisen, die in einer Halbleiterzone (35) von dem ersten Leitfähigkeitstyp gebildet sind, mit den Schritten:
    Bilden dicker Oxid-Zonen (37b) auf der Halbleiterzone (35) von dem ersten Leitfähigkeitstyp zwischen benachbarten Transistoren mit Source/Drain-Zonen (48) von dem zweiten Leitfähigkeitstyp und Bilden von Isolier-Gates (43) von einem ersten Leitfähigkeitstyp auf den Oxid-Zonen (37b);
    Bilden dicker Oxid-Zonen (37b) auf der Halbleiterzone (34) von dem zweiten Leitfähigkeitstyp zwischen benachbarten Transistoren (36) mit Source/Drain-Zonen (42) von dem ersten Leitfähigkeitstyp und Bilden von Isolier-Gates (46) von einem zweiten Leitfähigkeitstyp auf den Oxid-Zonen (37b); und
    Bilden von Zwischenverbindungen zwischen den Isolier-Gates und einer vorbestimmten Spannung.

8. Verfahren nach Anspruch 7, bei dem der Schritt des Bildens des Isolier-Gates die folgenden Schritte enthält:
    Bilden einer Polysilizium-Schicht über der Halbleiterzone (34, 35) von dem ersten und dem zweiten Leitfähigkeitstyp;
    Entfernen von Abschnitten der Polysilizium-Schicht zur Festlegung von Gates für die MOS-Transistoren und der Isolier-Gates;
    Dotieren der Isolier-Gates (46) zwischen Source/Drain-Zonen (42) von dem ersten Leitfähigkeitstyp mit einem Dotierstoff von dem zweiten Leitfähigkeitstyp; und
    Dotieren der Isolier-Gates (43) zwischen Source/Drain-Zonen (48) von dem zweiten Leitfähigkeitstyp mit einem Dotierstoff von dem ersten Leitfähigkeitstyp.

9. Verfahren nach Anspruch 8, bei dem der Schritt des Dotierens der Isolier-Gates (46) zwischen Source/Drain-Zonen (42) von dem ersten Leitfähigkeitstyp die folgenden Schritte enthält:

Bilden einer ersten Maske, die die Source-/Drain-Zonen (42) von dem ersten Leitfähigkeitstyp und Isolier-Gates (43) zwischen Source-/Drain-Zonen (48) von dem zweiten Leitfähigkeitstyp freilegt; und

Dotieren der durch die erste Maske freigelegten Source/Drain-Zonen und Isolier-Gate-Zonen mit einem Dotierstoff von dem ersten Leitfähigkeitstyp.

10. Verfahren nach Anspruch 9, bei dem der Schritt des Dotierens der Isolier-Gates (43) zwischen Source/Drain-Zonen (48) von dem zweiten Leitfähigkeitstyp die folgenden Schritte enthält:

Bilden einer zweiten Maske, die die Source/Drain-Zonen (48) von dem zweiten Leitfähigkeitstyp und Isolier-Gates (46) zwischen Source-/Drain-Zonen (42) von dem ersten Leitfähigkeitstyp freilegt; und

Dotieren der durch die zweite Maske freigelegten Source/Drain-Zonen und Isolier-Gate-Zonen mit einem Dotierstoff von dem zweiten Leitfähigkeitstyp.

11. Verfahren nach Anspruch 7, bei dem der Schritt des Bildens von Zwischenverbindungen den Schritt des Bildens von Zwischenverbindungen zwischen den Isolier-Gates und Erdspannung enthält.

## Revendications

1. Circuit intégré comprenant un transistor MOS isolant (30) pour fournir une isolation entre deux dispositifs MOS à canal N (10,12), ledit transistor MOS d'isolation (30) comprenant :
   - une région semi-conductrice de type P (28);
   - deux régions drain/source de type N (16b, 20b) formées dans la région semi-conductrice de type P (28), l'une desdites régions drain/source (16b) étant associée avec l'un (10) des dispositifs à canal N, et l'autre région drain/source (20b) étant associée avec l'autre dispositif à canal N (12); et
   - une région de grille (32) séparée de ladite région semi-conductrice de type P (28) par une couche d'isolation épaisse (29) et définissant un canal entre lesdites régions drain/source (16b, 20b), ladite région de grille (32) étant connectée à une tension prédéterminée pour rendre ledit canal non-conducteur, caractérisé en ce que ladite région de grille (32) est d'une conductivité de type P pour fournir une tension de seuil augmentée et réduire ainsi la possibilité de conduction par inadvertance entre lesdites régions drain/source (16b,20b).

2. Circuit intégré selon la revendication 1, dans lequel lesdites régions drain/source (16b, 20b) comprennent des régions de diffusion de type N+.

3. Circuit intégré selon la revendication 1, dans lequel ladite tension prédéterminée est la tension de terre.

4. Circuit intégré selon la revendication 1, comprenant en outre un second transistor MOS d'isolation pour fournir une isolation électrique entre des transistors à canal P ayant des régions drain/source de type P formées dans une région semi-conductrice de type N, ledit second transistor MOS d'isolation comprenant des régions de grilles de type N séparées de la région semi-conductrice de type N entre l'un des transistors à canal N et à canal P.

5. Procédé pour fournir une isolation entre deux régions diffusées de type N (16b,20b) disposées dans une région semi-conductrice de type P (28), comprenant les étapes de :
   - fourniture d'une région de grille au polysilicium de type P (32) séparée de la portion de la région semi-conductrice (28) entre les régions diffusées (16b, 20b) par une couche isolante épaisse (29); et
   - application d'une tension prédéterminée à la région de grille au polysilicium (32).

6. Procédé selon la revendication 5, dans lequel ladite étape d'application d'une tension prédéterminée comprend l'étape d'application d'une tension de terre à ladite grille au polysilicium (32).

7. Procédé pour former des transistors MOS isolés (36) dans un circuit intégré, certains des transistors (36) ayant des régions drain/source (42) d'un premier type de conductivité formées dans une région semi-conductrice (34) d'un second type de conductivité et les autres des transistors ayant des régions drain/source (48) du second type de conductivité formées dans une région semi--conductrice (35) du premier type de conductivité, comprenant les étapes de :
   - formation de régions d'oxyde épaisses (37b) sur la région semi-conductrice (35) du premier type de conductivité entre des transistors adjacents ayant des régions drain/source (48) du second type de conductivité et formation de grilles isolantes (43) d'un premier type de conductivité sur lesdites régions d'oxyde (37b);

- formation de régions d'oxyde épaisses (37b) sur la région semi-conductrice (34) du second type de conductivité entre des transistors adjacents (36) ayant des régions drain/source (42) du premier type de conductivité et formation de grilles isolantes (46) d'un second type de conductivité sur lesdites régions d'oxyde (37b); et

- formation d'interconnexions entre lesdites grilles isolantes et une tension prédéterminée.

8. Procédé selon la revendication 7, dans lequel l'étape de formation de ladite grille isolante comprend les étapes de :
   - formation d'une couche au polysilicium sur la région semi-conductrice (34,35) des premier et second types de conductivité;
   - enlèvement de portions de ladite couche au polysilicium pour définir des grilles pour les transistors MOS et lesdites grilles isolantes;
   - dopage des grilles isolantes (46) entre des régions drain/source (42) du premier type de conductivité avec un dopant d'un second type de conductivité; et
   - dopage des grilles isolantes (43) entre des régions drain/source (48) du second type de conductivité avec un dopant du premier type de conductivité.

9. Procédé selon la revendication 8, dans lequel ladite étape de dopage desdites grilles isolantes (46) entre des régions drain/source (42) du premier type de conductivité comprend les étapes de :
   - formation d'un premier masque d'exposition des régions drain/source (42) du premier type de conductivité et des grilles isolantes (43) entre des régions drain/ source (48) du second type de conductivité; et
   - dopage des régions drain/source et des régions de grilles isolantes exposées par ledit premier masque avec un dopant du premier type de conductivité.

10. Procédé selon la revendication 9, dans lequel l'étape de dopage des grilles isolantes (43) entre des régions drain/source (48) du second type de conductivité comprend les étapes de :
    - formation d'un second masque d'exposition des régions drain/source (48) du second type de conductivité et des grilles isolantes (46) entre des régions drain/ source (42) du premier type de conductivité, et

- dopage des régions drain/source et des régions de grilles isolantes exposées par ledit second masque avec un dopant du second type de conductivité.

11. Procédé selon la revendication 7, dans lequel l'étape de formation des interconnexions comprend l'étape de formation d'interconnexions entre les grilles isolantes et la tension de terre.

FIG. 1 (PRIOR ART)

FIG. 2

FIG. 3a

FIG. 3b